(19) Europäisches Patentamt European Patent Office Office européen des brevets

(11) **EP 3 624 207 B1**

(12) **EUROPEAN PATENT SPECIFICATION**

(45) Date of publication and mention of the grant of the patent:
**01.11.2023 Bulletin 2023/44**

(21) Application number: **19195450.2**

(22) Date of filing: **30.09.2014**

(51) International Patent Classification (IPC):
*H10K 50/858* (2023.01)   *H10K 50/844* (2023.01)
*H10K 71/80* (2023.01)   *H10K 77/10* (2023.01)
*H10K 50/84* (2023.01)

(52) Cooperative Patent Classification (CPC):
**H10K 71/80; H10K 50/841; H10K 50/844;
H10K 50/858; H10K 77/111;** H10K 2102/311;
Y02E 10/549; Y02P 70/50

(54) **METHODS TO FABRICATE FLEXIBLE OLED LIGHTING DEVICES**

VERFAHREN ZUR HERSTELLUNG FLEXIBLER OLED-BELEUCHTUNGSVORRICHTUNGEN

PROCÉDÉS POUR FABRIQUER DES DISPOSITIFS D'ÉCLAIRAGE OLED SOUPLE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.09.2013 US 201314042194**

(43) Date of publication of application:
**18.03.2020 Bulletin 2020/12**

(62) Document number(s) of the earlier application(s) in accordance with Art. 76 EPC:
**14187068.3 / 2 854 193**

(73) Proprietor: **Universal Display Corporation
Ewing, NJ 08618 (US)**

(72) Inventors:
• **MA, Ruiqing
Ewing, NJ 08618 (US)**
• **BROWN, Julia J.
Ewing, NJ 08618 (US)**

(74) Representative: **Maiwald GmbH
Elisenhof
Elisenstraße 3
80335 München (DE)**

(56) References cited:
WO-A1-2008/139370    WO-A2-2004/051738
JP-A- 2005 327 687    US-A1- 2012 228 601

**Description**

BACKGROUND OF THE INVENTION

Field of the Invention

WO 2008/139370A1 describes a method for the manufacturing of an optoelectronic device. The method comprises the steps of: providing a substantially rigid carrier substrate having a structured surface; depositing a substrate over the structured surface of the carrier substrate so that the inverse of the structured surface is formed on the deposited substrate; forming at least one optoelectronic unit on the deposited substrate opposite the carrier substrate; and releasing the deposited substrate and the at least one optoelectronic unit from the carrier substrate using radiation after forming the at least one optoelectronic unit.

WO 2004/051738A2 describes a method for the manufacture of displays. A substrate provided with small openings, rendering the substrate porous and forming trenches in the substrate, is used. A removable layer is attached to the substrate. An etch and temperature resistant layer is deposited onto the removable layer, and a display is processed on said etch and temperature resistant layer. The removable layer is removed by etching through the openings in the substrate and the substrate may be re-used.

US 2012/228601A1 describes an organic electroluminescence element containing a light transmissive base material laminated thereon a transparent electrode, a light emitting layer and a counter electrode in this order, wherein the light transmissive base material contains a light transmissive resin substrate provided with a hard coat layer on both surfaces of the light transmissive resin substrate, the hard coat layers containing metal oxide nano particles; and the transparent electrode is formed on one hard coat layer; and a rugged structure is formed on one surface of the other hard coat layer, the one surface being opposite to another surface of the other hard coat layer which is contacted with the light transmissive resin substrate.

The present invention relates to methods for fabricating flexible OLED lighting devices. Background

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745.

BRIEF SUMMARY OF THE INVENTION

The present invention provides a method of fabricating an organic light emitting device (OLED) on a substrate as described in claim 1. Further details are described in dependent claims.

In some embodiments, the surface features of the mold have a peak-to-trough height of at least 200 nm.

In some embodiments, the surface features of the mold have a peak-to-trough height of at least 1 micron.

In some embodiments, the surface features of the mold have a peak-to-trough height of at most 100 microns.

In some embodiments, the method further includes applying a release coating over the mold prior to forming the substrate.

In some embodiments, the substrate is formed directly over the mold without any intervening layers.

In some embodiments, the substrate is formed by applying a coating over the mold. In some embodiments, the coating is formed by applying a liquid to the mold, and subsequently curing the liquid prior to fabricating the OLED.

In some embodiments, the method further includes applying a barrier layer over the substrate before fabricating the OLED.

In some embodiments, the method further includes depositing a barrier layer over the OLED before removing the mold from the substrate.

In some embodiments, after removing the mold from the substrate, the substrate having the OLED fabricated thereon has a flexural rigidity sufficiently low that the substrate can be wrapped around a 12-inch diameter roll without breaking.

In some embodiments, a material and thickness of the coating result in a substrate that is flexible if not supported by the mold.

In some embodiments, there is a mismatch in the coefficients of thermal expansion of the mold and the substrate.

In some embodiments, a refractive index of the substrate is greater than 1.6. In some embodiments, the refractive index of the substrate is greater than 1.7.

Further the invention provides an apparatus as described in claim 9.

In some embodiments, the substrate is transparent.

In some embodiments, the surface features of the mold result in the substrate having formed thereon surface features selected from spherical lenses, aspherical lenses, groves, prisms, and irregular features that have larger dimensions at the base.

In some embodiments, the device is a lighting device.

BRIEF DESCRIPTION OF THE DRAWINGS/FIGURES

The accompanying drawings, which are incorporated herein and form a part of the specification, illustrate embodiments of the present invention and, together with the description, further serve to explain the principles of the invention and to enable a person skilled in the pertinent art to make and use the invention.

FIG. 1 shows an exemplary organic light emitting device.
FIG. 2 shows an exemplary inverted organic light emitting device that does not have a separate electron transport layer.
FIG. 3 is a flow chart of an exemplary process for fabricating an OLED on a mold.
FIG. 4 is a flow chart of an exemplary process for fabricating an OLED.
FIG. 5 is a flow chart of another exemplary process for fabricating an OLED on a mold.
FIGs. 6A-G are exemplary views of transient structures formed during the OLED fabrication process shown in FIG. 5.
FIGs. 7A-C are exemplary views of the mold and removal process according to some embodiments, not forming part of the claimed invention.
FIG. 8 is an exemplary view of a conveyor belt apparatus used in some embodiments of fabricating an OLED.

DETAILED DESCRIPTION OF THE INVENTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. Examples include Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"). Phosphorescence is described in more detail in US Pat. No. 7,279,704 at cols. 5-6.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

More details on OLEDs, and the definitions described above, can be found in US Pat. No. 7,279,704.

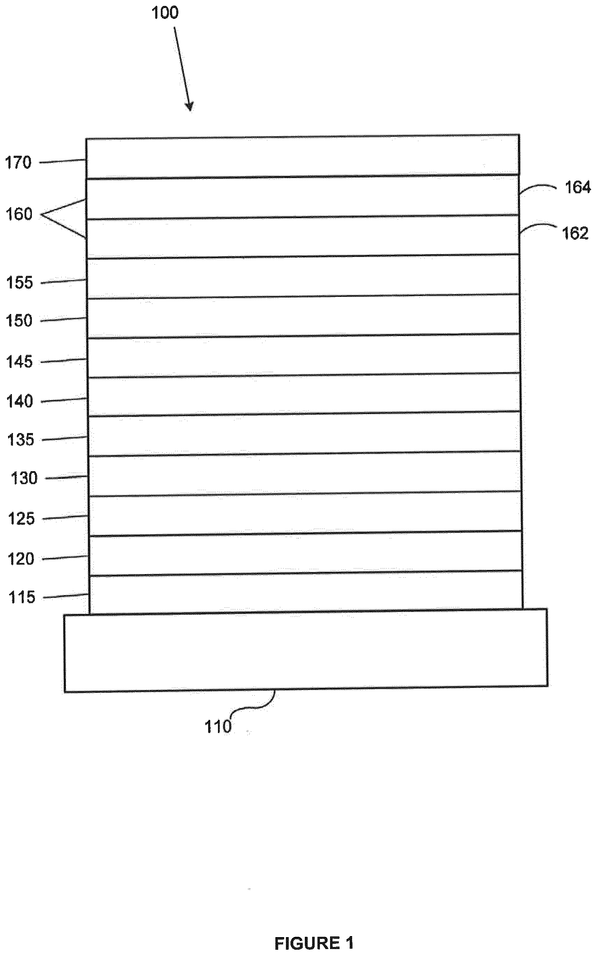

FIG. 1 shows an exemplary organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844, 363. An example of a p-doped hole transport layer is m-MTDATA doped with $F_4$-TCNQ at a molar ratio of 50:1, as disclosed in U.S. Patent Application Publication No. 2003/0230980. Examples of emissive and host materials are disclosed in U.S. Pat. No. 6,303,238 to Thompson et al. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707, 745, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

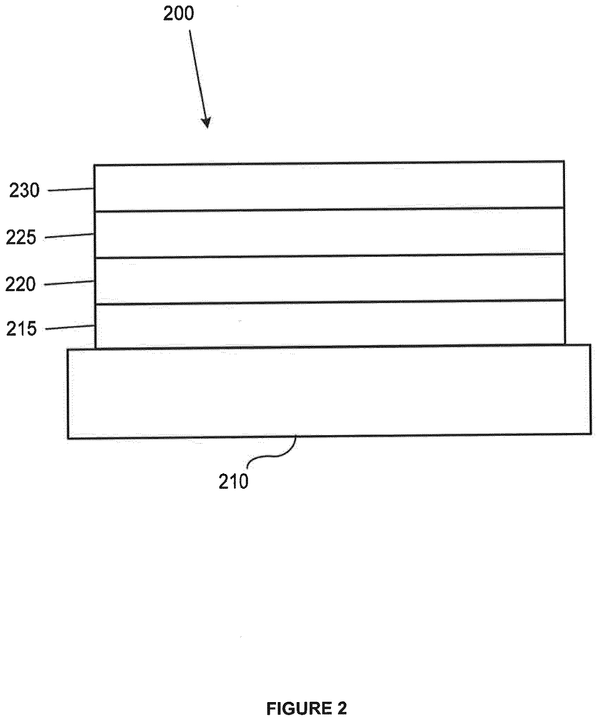

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al. By way of further example, OLEDs having a single organic layer may be used. OLEDs may be stacked, for example as described in U.S. Pat. No. 5,707,745 to Forrest et al. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al, and deposition by organic vapor jet printing (OVJP), such as described in U.S. Pat. No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

**Methods for Fabricating Flexible OLEDs**

Building flexible OLED lighting devices on flexible substrates provide both benefits and challenges. It is easier to obtain a high refractive index from transparent plastic materials than from conventional glass substrates. This enables a better outcoupling efficiency for OLEDs on plastic. However, a flexible plastic film is very difficult to handle. Keeping it flat during fabrication process can be a challenge. Another challenge with plastic substrates is that they tend to have rough surfaces and random spikes on the surface. These defects can easily cause shorting in the OLED devices grown on them. However, the methods described herein overcome both these challenges.

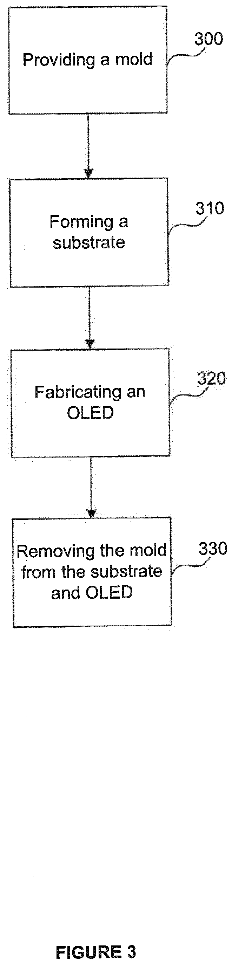

FIG. 3 is a high level flowchart of an exemplary method for fabricating an OLED on a substrate including a step 300 of providing a mold, a step 310 of forming a substrate, a step 320 of fabricating an OLED, and a step 330 of removing the mold from the substrate and OLED. The process shown in FIG. 3 is merely exemplary and can include additional steps or fewer steps.

Step 300 includes providing a mold. The mold can have at least two functions: i) to act as a support during the following process steps; and ii) to generate the desired surface features on the flexible substrate to be formed on the mold in the next step. Thus, the mold can be designed to provide the desired surface features. The surface features are preferably designed to efficiently extract light from the OLED device.

The surface features on the mold are designed to produce features on the substrate that will be formed in the next step. The surface features to be made can be spherical lenses, aspherical lenses, groves, prisms, irregular features that have larger dimensions at the base, or any other topographical features that enhance light extraction. This is especially beneficial to OLED lighting devices. In some embodiments, the lens features can be radially symmetric about an axis normal to the flat surface of the mold. A spherical lens can be a hemispherical shape with H/R=1 where H and R are the peak to trough height and radius (in the plane) of the lens. Aspheric lens shape can be defined by a polynomial such as quadratic, cubic, parabolic. The aspheric lens can be shaped such that lens height H over radius R, H/R>1, H/R>2.

In some embodiments, the peak to trough height H of the surface features should be at least comparable to the thickness of the OLED device (~100 nm). In other embodiments, H should be at least comparable to or greater than the wavelength of the light in the substrate (wavelength in vacuum divided by refractive index of the substrate material) generated in the OLED device deposited thereafter. For example, when the index of the substrate is 2.0, H should be at least comparable to 200 nm or greater. Thus in some embodiments H, can be 400 nm or greater. These minimum dimensions are preferred because, at smaller dimensions, the optics and outcoupling may be less desirable. It can also be preferred to have larger minimum dimensions to help the fabrication of the surface features on the mold. In such embodiments, the preferred H can be at least 1 $\mu$m, at least 5 $\mu$m, at least 10 $\mu$m, at least 50 $\mu$m or at least 100 $\mu$m. These minimum values for H are preferred because, as the minimum becomes larger, it becomes easier to fabricate the mold features. But, minimums different from those disclosed in this paragraph may be used depending on whether it is acceptable to trade-off optical considerations and ease of manufacturing for other considerations.

In some embodiments, the peak to trough height H of the surface features should be at most 300 $\mu$m, and preferably at most 100 $\mu$m. At larger values for H, undesirable effects may occur. For example, bubbles may form if a single thick coat is used. While these effects may be mitigated by using multiple coating steps, or through material and process parameter selection, such mitigation involves its own trade-offs. Also, if overall thickness becomes too large, flexibility may decrease, which may be undesirable for some uses.

In some embodiments, the surface features can cover an area or form an area array. Preferably, a center-to-center lateral distance between adjacent surface features is not more than ten times the value of H.

The surface features can be arranged regularly or randomly. The size can be uniform or different. It is preferred that the surface features are packed closed together with a fill factor of at least 80%, at least 90%, or at least 95%. Here Fill Factor is defined as the ratio of the surface area occupied by surface features (projection of the surface features on the base surface) over the base surface area.

In some embodiments, not being part of the claimed invention, the mold can be rigid. This means that the mold is rigid enough to be able to withstand, without significant flexing or distortion, the normal handling associated with semiconductor or standard glass based flat panel display fabrication - i.e., the mold can easily be picked up and moved around without breaking or significantly bending. This allows the process to overcome the challenge of keeping the substrate formed on the mold flat during fabrication of the OLED. The rigidity of the mold can be determined by calculating its flexural rigidity D. This is defined as the force couple required to bend a rigid structure to a unit curvature. For a uniform substrate, flexural rigidity can be described mathematically as:

$$D = Et^3 / 12(1 - \mu^2) \qquad\qquad (1)$$

where D is flexural rigidity (in Nm), E is Young's modulus (in Nm$^{-2}$), $\mu$ is Poisson's ratio and t is the thickness of the substrate (in m). This equation is described in J. A. Rogers, G. R. Bogart, J. Mater. Res., 16 (1), 217, 2001. The more flexible the substrate, the lower the flexural rigidity. The flexural rigidity of any substrate can be theoretically calculated if Young's modulus, Poisson's ratio and the thickness of the substrate are known.

It may be difficult to calculate flexural rigidity for thin films from material properties or from data provided in a textbook. This is especially true for composite films or multilayer films. However, once a measurement is made for a particular structure, flexural rigidity can be readily altered in a reasonably predictable way by one of skill in the art by adjusting parameters such as substrate thickness. Here we focus on the cantilever method for determining flexural rigidity. The apparatus required is a fixed angle flexometer. A rectangular strip of material is supported on a horizontal platform in a direction perpendicular to the edge of the platform. The strip is extended in the direction of its length so that an increasing part overhangs and bends down under its own weight. When the tip of the strip of material has reached a plane passing through the edge of the platform and inclined at an angle of $\theta = 41.5°$ below the horizontal, the overhanging length L is equal to twice the bending length C of the specimen (C = 0.5L at $\theta = 41.5°$).

Bending length (in m) is denoted by C, where C is the cube root of the ratio of flexural rigidity to the weight per unit area of the material: D = WC$^3$, where W is weight per unit area (in Nm$^{-2}$), which for a uniform strip is given by W = $\rho$tg, such that:

$$D = WC^3 = \rho tgC^3 \qquad\qquad (2)$$

Where $\rho$ is density (in Kgm$^{-3}$), g is gravitation acceleration (9.81 ms$^{-2}$) and t is the thickness of the substrate (in m).

Here we use both equations 1 and 2 to determine the best mold substrate material/thickness combination to be used for making flexible electronics devices. Some examples are shown in Table 1 below. E, $\mu$, and $\rho$ are material properties and are determined once the material is selected.

**Table 1**

|  | E (G Pa) | $\mu$ | t (mm) | D | $\rho$ (Kg/m3) | g (m/s2) | C (m) |
|---|---|---|---|---|---|---|---|
| Borosilicate Glass | 65 | 0.2 | 0.7 | 2.015969 | 2230 | 9.81 | 0.50871 |
| Borosilicate Glass | 65 | 0.2 | 0.5 | 0.734682 | 2230 | 9.81 | 0.406492 |
| stainless steel | 200 | 0.3 | 0.5 | 2.515799 | 8020 | 9.81 | 0.399903 |
| stainless steel | 200 | 0.3 | 0.33 | 0.723282 | 8020 | 9.81 | 0.303145 |
| stainless steel | 200 | 0.3 | 0.1 | 0.020126 | 8020 | 9.81 | 0.136765 |

It is common practice in the flat panel display industry to use 0.7 mm or 0.5 mm glass for display fabrication. This means a flexural rigidity of >0.7 Nm is good enough for the process. Accordingly, in some embodiments, not being part of the claimed invention, the mold has a flexural rigidity of at least 0.7 Nm. When glass is used as the mold, the same thickness of glass can be applied. When a different mold material is used, the thickness of the material can be calculated to make sure a similar level of flexural rigidity is achieved. As can be seen in Table 1 above, stainless steel foil with a thickness of 0.33 mm has similar flexural rigidity as 0.5 mm borosilicate glass sheet. Another way to decide on the thickness of mold material is to use similar bending length. Stainless steel and glass at similar thickness give similar bending length.

In some embodiments, not being part of the claimed invention, the mold has a flexural rigidity greater than the flexural rigidity of an assembly of the substrate and an OLED, including when the OLED includes a hard coat.

In some embodiments, the mold can include a base layer and a patterned layer having the surface features. In some embodiments, the base layer has a flexural rigidity greater than the flexural rigidity of the patterned layer.

The material for the mold can depend upon the type of material used to form the substrate and the release process. The mold can be fabricated from a material with mechanical and optical properties suitable for the process. The type of mold used can depend upon the types of surface features required and the methods available to make the surface features. If a laser is used for release the substrate, then a transparent mold material such as glass is needed.

In some embodiments, the mold can be made directly using processes such as machining or 3D printing.

In other embodiments, the mold can be formed from a master with the same shape as the desired features. A master can be made using a wide variety of materials, including semiconductor wafers and photoresists traditionally used in microfabrication. Where a master is used, the mold itself can be made by any of a variety of methods that transfer features from the master to the mold. For example, a liquid can be applied over the master, cured to solidify, and removed. Other methods, including those described herein for forming the substrate from the mold, can be used.

The features required for a mold can be machined directly onto commercially available aluminum, hardened steel, or stainless steel pieces using micromachining techniques. These can include conventional CNC machining, laser cutting, and micro-electrical discharge machining ($\mu$-EDM). Metal molds can also be electroformed from a master immersed in a plating bath. These molds tend to be made from elemental metals such as Ni. Metal molds can also be used to emboss features into plastic sheets that have been softened by exposure to heat or solvent. When Si or glass are used to make a mold, surface features can be defined by standard semiconductor processing techniques.

Step 310 can include forming a substrate over the mold. As used herein, the term "over" means as measured in a direction moving away from the mold in the direction of the side of the mold with surface features, i.e., further away from the mold. The term over is intended to allow for one or more intermediate layers between the mold and the substrate. For example, where a first layer is described as "disposed over" or "formed over" a second layer, the first layer is disposed further away from mold. There may be other layers between the first and second layer, unless it is specified that the first layer is "in contact with" the second layer. For example, a cathode can be described as "disposed over" an anode, even though there are various organic layers between the cathode and anode.

In some embodiments, step 310 includes applying a liquid coating onto the mold and curing the coating to form the substrate over or on top of the mold. In some embodiments, the substrate can be transparent. In other embodiments, step 310 includes applying a solid coating onto the mold, heating the solid to form a melt wherein the melt conforms to the shape of the mold, and cooling the melt to form a solid substrate that conforms to the mold. In some embodiments, the material and thickness of the coating result in a substrate that is flexible if not supported by the mold. For example, Polyester substrate can be formed by melting the raw material (e.g. purified terephthalic acid (PTA)) and then cooled to form films. In this invention, solution deposition is preferred because of low heat and better surface quality. The thickness of the film is preferred to be larger than the height of the surface feature H. It can range from 5 $\mu$m to a few hundred $\mu$m.

In some embodiments, the substrate is formed directly over the mold without any intervening layers such that the substrate directly contacts the mold. In other embodiments, there can be one or more intervening layers between the mold and the substrate, such as, for example, a release layer.

In some embodiments, the refractive index of the substrate material can have a difference of less than 0.1 or 0.2 from the refractive index of the organic emissive materials. A high refractive index (>1.6) is preferred for better light extraction efficiency. The most preferred refractive index is a value higher than the refractive index of the light generating layer (>1.7).

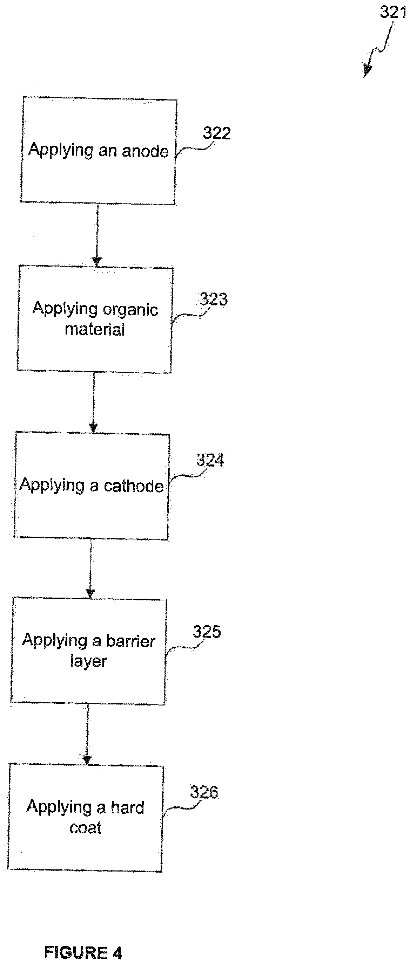

Step 320 can include forming an OLED over the substrate while the substrate is attached to the mold. The process for forming an OLED will be discussed in more detail below with reference to FIG. 4. In some embodiments, prior to forming the OLED, a barrier layer is applied over the substrate. In some embodiments, prior to forming the OLED, bus lines can be fabricated over the substrate.

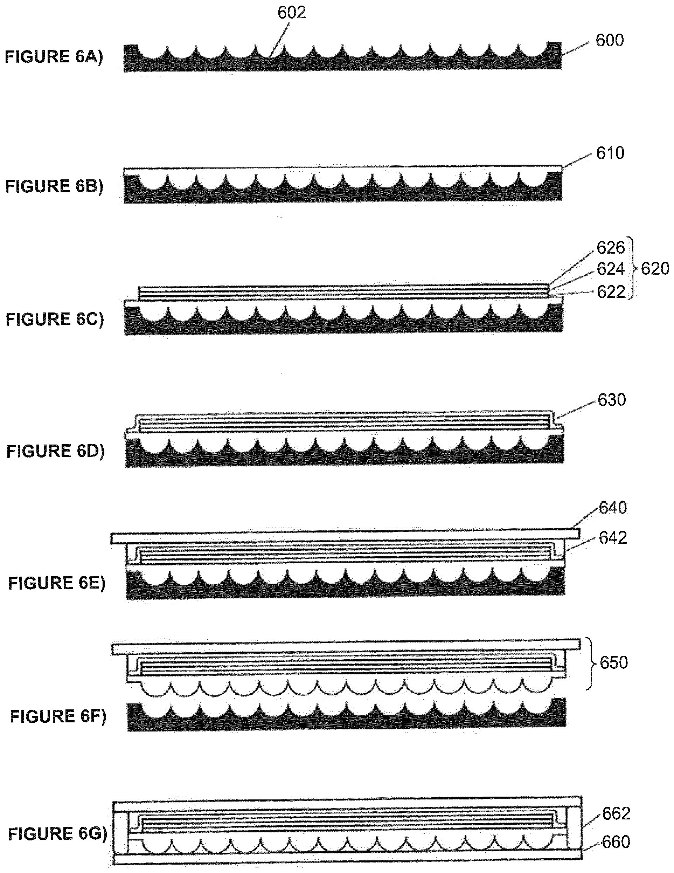

Step 330 can include removing the mold from the substrate having the OLED fabricated thereon. The substrate and OLED can be removed from the mold in a number of different ways as described in more detail below with reference to FIGs. 6-8.

FIG. 4 illustrates an exemplary OLED fabrication process 321 that can be used in step 320. Process 321 can include a step 322 of applying an anode, a step 323 of applying organic material, a step 324 of applying a cathode, a step 325 of applying a barrier layer, and a step 326 of applying a hard coat. Fabrication process 321 is merely exemplary and can include additional steps or fewer steps. For example, it can also include steps for forming layers present in OLED device 100 or 200, but not specified in fabrication process 321. The order of steps can also be rearranged. For example, if an inverted OLED, such as that described in reference to FIG. 2, is desired, then steps 322 and 324 can be reordered.

Step 322 can include applying an anode over the substrate. Any suitable method can be used including, but not limited to, sputtering, photolithography, and other wet or dry processes.

Step 323 can include applying organic material over the anode. The organic material can include one or more layers of suitable material including, but not limited to, HIL (hole injection transport), HTL (hole transport layer), EML (emissive layer), HBL (hole blocking layer), EIL (electron injection transport), ETL (electron transport layer), and EBL (electron blocking layer). The organic material can be applied using any suitable method including, but not limited to thermal evaporation, ink-jet printing, organic vapor phase deposition (OVPD), deposition by organic vapor jet printing (OVJP), and spin coating and other solution based processes.

Step 324 can include applying a cathode over the organic material. Any suitable method can be used including, but not limited to, sputtering, photolithography, and other wet or dry processes.

Step 325 can include applying a barrier layer over the OLED to encapsulate the OLED. In some embodiments, the barrier layer is a thin film so that the OLED is flexible. The barrier layer can include inorganic, organic, and hybrid materials. The application process can include, but is not limited to, sputtering, plasma-enhanced chemical vapor deposition (PECVD), atomic layer deposition (ALD), and other thin film deposition processes.

Step 326 can include applying a hard coat layer over the barrier layer to provide extra protection to the OLED. In addition to providing a mechanical protection layer, the hard coat layer can facilitate removing the mold from the substrate and OLED device.

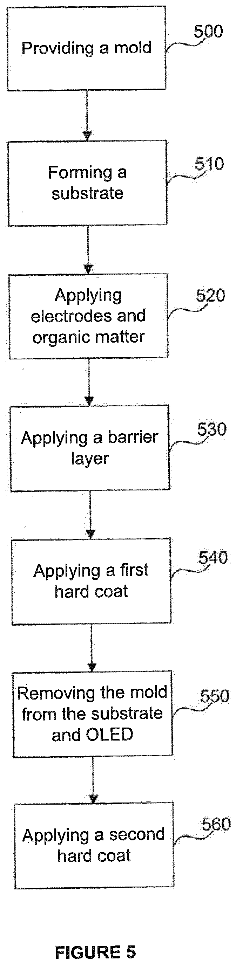

FIG. 5 is an exemplary flowchart of a method for fabricating a flexible OLED on a substrate which can include one or more of the steps previously described in reference to FIGs. 3 and 4. The method can include a step 500 of providing a mold, a step 510 of forming a substrate, a step 520 of applying electrodes and organic matter, a step 530 of applying a barrier layer, a step 540 of applying a first hard coat, a step 550 of removing the mold from the substrate and OLED, and a step 560 of applying a second hard coat. The method of FIG. 5 is merely exemplary and can include additional or fewer steps. The order of steps can also be rearranged. A more detailed discussion of each of the steps follows, along with a discussion of accompanying FIGs. 6A-6G, which illustrates views of transient structures formed after each step of the method outlined in FIG. 5.

Step 500 can include providing a mold and can correspond to step 300 discussed above in reference to FIG. 3. In some embodiments, as shown for example in FIG. 6A, a mold 600 can include one or more surface features, for example concave structures 602. As used herein, the term "concave" means a surface that curves inward. For example, the outside surface of a sphere is convex, an inside surface of a sphere is concave. When concave structures 602 are shaped to form microspheres on the substrate, mold 600 resembles an empty egg carton.

Step 510 can include forming a substrate over the mold and can correspond to step 310 as discussed above in reference to FIG. 3. In some embodiments, as shown for example in FIG. 6B, substrate 610 can be thicker than the depth of concave structures 602 so that the top surface of substrate 610 is smooth and continuous. This can overcome the challenge of the substrate have a rough surface with random spikes. If the top surface of substrate 610 is not smooth enough, a planarization layer (not shown) can be applied on top. To help prevent any moisture or other detrimental gas/chemicals from migrating into the OLED, a barrier layer (not shown) can be deposited on top of the substrate. This barrier layer can also protect the underlying substrate layer when chemicals are used in the following steps (e.g., in a photolithography process).

Step 520 can include applying the electrodes and organic matter and can correspond to steps 322, 323, and 324 discussed above in reference to FIG. 3. In some embodiments, as shown for example in FIG. 6C, an OLED 620 can be formed comprising two electrodes 622 and 626 with organic material 624 sandwiched between electrodes 622 and 626. One or more OLEDs 620 can be formed on substrate 610. In some embodiments, OLED 620 can be a bottom emission OLED such that electrode 622 is an anode and electrode 626 is a cathode. In some embodiments, anode 622 is transparent and can be applied over substrate 610 according to any of the methods discussed above with respect to step 322. In some embodiments, anode layer 622 can be patterned and/or can include extra buslines to help distribute current. In such instances, anode layer 622 can include insulating material for patterning and/or extra conductive materials for the extra buslines. These can be formed using standard photolithography processes or other wet or dry processes. After anode layer 622 is formed, one or more organic layers 624 can be formed over anode layer 622 in accordance with the processes discussed above with respect to step 323. Next, cathode layer 626 can be formed over organic layers 624 in accordance with the processes discussed above with respect to step 324. In some embodiments, additional layers can be deposited over cathode 626. For example, a buffer layer (not shown) can be deposited over cathode 626.

Step 530 can include applying a barrier layer and can correspond to step 325 as discussed above in reference to FIG. 3. In some embodiments, as shown for example in FIG. 6D, a barrier layer 630 is deposited over OLED device 620 and can include oxide, nitride, ceramic, or hybrid materials. In some embodiments, barrier layer 630 is sufficiently thin in thickness so that the OLED device is flexible.

Step 540 can include applying a hard coat and can correspond to step 326 as discussed above in reference to FIG. 3. In some embodiments, as shown for example in FIG. 6E, a hard coat 640 can be attached to barrier layer 630 via a glue layer 642. In some embodiments, hard coat 640 has barrier properties to prevent exposure to harmful species in the environment including moisture, vapor and/or gases. Materials for hard coat 640 can include, but are not limited to, glass, metal foil, or a barrier coated plastic film.

In some embodiments, after step 520, 530, or 540, as shown for example in FIGs. 6C-6E, respectively, a transient structure exists including a mold 600 having surface features, a substrate 610 formed over the mold and an OLED 620 fabricated over the substrate. As discussed above, substrate 610 can be transparent and can have a thickness such that the substrate is flexible in the absence of the mold. Such a transient structure exists during manufacturing and in some embodiments can be shipped or stored in this state before the remaining steps of the process, such as removal of the mold, are performed.

Step 550 can include removing the mold from the substrate and OLED and can correspond to step 330 discussed above in reference to FIG. 3. In some embodiments, as shown for example in FIG. 6F, an assembly 650 of OLED 620 and substrate 610 can be removed from mold 600. The release step can be performed using a variety of different means.

In some embodiments, not being part of the claimed invention, removal involves an application of force to separate mold 600 from assembly 650. As long as the adhesion between substrate 610 and mold 600 is the weakest among all interfaces, the substrate will be detached from the mold.

In some embodiments, not being part of the claimed invention, mold 600 is dissolved, thereby removing the mold from assembly 650. For example, a mold can be made by forming topographical features using photoresist on a flat piece of glass. Photoresist is a standard material used for patterning purposes in photolithography processes, and can be easily removed afterwards. For example, a typical positive resist S1813, provided by Shipley, may be dissolved in acetone before hard baking. Even after hard baking, such as 150C baking, S1813 may still be removed by photoresist remover 1165, provided by Shipley, at an elevated temperature.

In some embodiments, not being part of the claimed invention, a thermal approach can be taken to perform the removal. For example, assembly 650 and mold 600 can be heated or cooled. As a result of the mismatch of thermal expansion of mold and substrate material, the substrate can be separated from the mold. The coefficient of thermal expansion (CTE) values of some of the materials used for the mold and substrate are shown in Table 2. Typical plastic materials have very large CTE values. When paired with a mold made out of low CTE materials (e.g., Si, glass, stainless, or steel), the plastic materials can be easily released from the mold by cooling down the whole component (the plastic shrinks substantially more than the mold and as a result separates itself from the mold). For example, assume a 100 $\mu$m thick substrate coating is applied on top of the mold at room temperature. The CTE mis-match is about $50\times10^{-6}$/K (plastic on glass/Si mold). When the whole component is cooled down 20 degrees Kelvin, the dimension change between the substrate and mold is $100\times50\times10^{-6}\times20=0.1$ $\mu$m, which is a significant change and can cause the separation of the substrate from the mold.

**Table 2**

| Material | Si | Glass | Stainless Steel | Typical plastic |
|---|---|---|---|---|
| CTE (ppm/K) | 3 | 3~9 | 17 | 40~70 |

A light source can also be used to trigger the release of the substrate. Ultraviolet, infrared or visible light sources can be used to locally heat up the interface between the substrate and the mold. The light source can include a laser. To facilitate this process, a release coating (not shown) which absorbs the photo energy, can be deposited over mold 600 before forming substrate 610 between steps 500 and 510. Oxide material such as $SiO_2$, $Al_2O_3$ and transparent conductive oxide material ITO can be used to convert light to heat. The thickness can range from a few nm to 100 nm.

In some embodiments, a poor adhesion between substrate 610 and mold 600 can be achieved by treating the mold surface such that it has a low surface energy, for example through the application of a release coating to mold 600 between steps 500 and 510. The low surface energy release coating can include, but is not limited to fluorinated polymers (e.g., Teflon), siloxanes, or silicones. In some embodiments, not being part of the claimed invention, when the mold is Si (e.g., oxidized Si) or glass, the low surface energy release coating can be fluorinated silane.

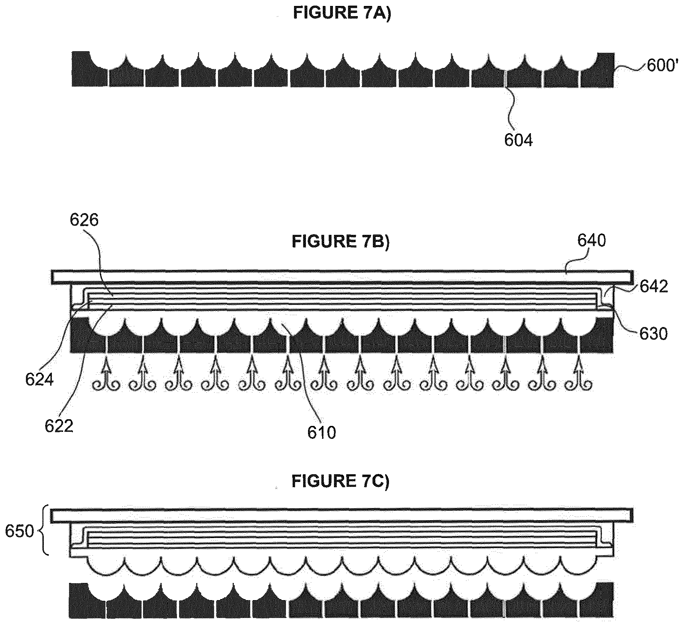

In some embodiments, not being part of the claimed invention, a liquid or gas can be used to remove the mold from the assembly of the OLED device and substrate. As shown for example in FIGs. 7A-7C, mold 600' can have a plurality of holes 604 extending through the entire thickness of mold 600'. These holes 604 can provide access to the substrate 610 from the backside of the mold. During removing step 550, a liquid or gaseous substance, for example a chemical or water (either in the liquid or gas forms), can travel through holes 604 and change the interface adhesion between substrate 610 and mold 600' to facilitate removal of mold 600' from assembly 650. In other embodiments, mechanical force can be applied through holes 604. This mechanical force can be applied, for example, by using, a solid substance (e.g., pins), a liquid substance (e.g., a hydraulic liquid) or gaseous substance. One example of using gas can include sending a high pressure gas through holes 604 to push substrate 610 off mold 600'.

In some embodiments, the dimension of the holes are sized to ensure they are not too large in order to avoid decreasing the effective lens surface and to minimize the substrate from leaking through the holes when the substrate is formed. In some embodiments the holes take less than 10% of the base area of each individual lens. For example, for a hemispherical lens with a radius of 5 $\mu$m, the hole radius should be less than 1.6 $\mu$m. It can be preferred to have a very small hole such that the coating will not fill into the through hole due to the surface tension of the coated material. For standard photolithography process, a sub-micron size (e.g., 0.5 $\mu$m) is possible with an ultraviolet light source. The surface of the mold can be treated to facilitate this process.

Once the mold is removed, the substrate having the OLED fabricated thereon is flexible. For example, in some embodiments, the substrate having the OLED fabricated thereon can have a flexural rigidity sufficiently low that the substrate can be wrapped around a 12-inch diameter roll without breaking.

As shown for example in FIG. 6F, once the mold is removed, the substrate includes surface features complementary to the surface features of the mold from which it was removed. For example, a spherical indentation in the mold will lead to a complementary spherical bulge on the substrate of similar radius. As used herein, "complementary" allows for minor differences caused, for example, by the presence of a release layer having some thickness and irregularity between the substrate and the mold. In some embodiments, at least some of the surface features on the substrate are convex.

Turning back to FIG. 5, step 560 can include applying a second hard coat after step 550 to the outcoupling side of the device to provide extra mechanical protection and barrier protection. In some embodiments, as shown for example in FIG. 6G, a hard coat 660 can be applied to substrate 610. A thin piece of glass or a barrier coated plastic can be used for hard coat 660. In some embodiments, hard coat 660 can have an anti-reflective coating on both sides. Hard coats 640 and 660 can be attached together by a glue layer 662. In some embodiments, glue layer 662 is flexible and has barrier properties. A desiccant material can be included inside the assembly between hard coats 640 and 660 to provide extra protection from moisture and oxygen.

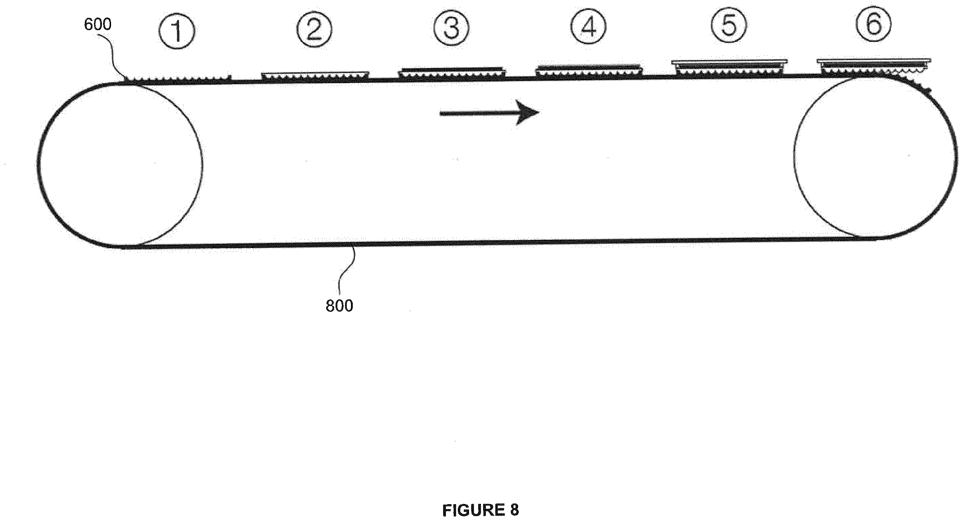

Steps 500 through 550 occur on a conveyor belt apparatus as shown for example, in Figure 8. Stations 1 through 6 correspond with steps 500 through 550, respectively, and with the structures shown in FIGs. 6A-6F, respectively. According to the claimed invention, a flexible mold 600 is needed. The mold 600 is attached to a conveyor belt 800 and as the mold moves with the conveyor belt, different materials will be deposited on the mold. In other embodiments, the conveyor belt 800 can be the mold 600. At the end of the process, the mold will bend around the roller and when the substrate-mold interface is the weakest interface, the assembly of the substrate and the OLED will peel off from the mold. The mold is more flexible than the assembly of the substrate and the OLED. This is because the hard coat makes the assembly more rigid than the mold. In such embodiments, the mold can be made out of thinner materials so it can bend around the rollers of the conveyor belt. According to the claimed invention, the corresponding apparatus can include belt 800; a mechanism to move the belt, which can be any conventional belt driving means; and a flexible mold disposed on the belt, wherein the flexible mold has surface features. The apparatus can also include the following in sequential order along a path of the belt: a dispenser attached to a source of substrate material; an energy source adapted to treat the substrate material; a plurality of dispensers attached to sources for applying the materials making up the components of the OLED; and a mechanism adapted to remove the assembly of the substrate material and OLED from the mold disposed on the belt. As discussed above, the mechanism adapted to remove the assembly can hold the OLED device as the substrate peels from the mold when the belt bends around the rollers.

Devices fabricated in accordance with embodiments of the invention may be incorporated into a wide variety of consumer products, including flat panel displays, lighting devices, computer monitors, medical monitors, televisions, billboards, lights for interior or exterior illumination and/or signaling, heads up displays, fully transparent displays, flexible displays, laser printers, telephones, cell phones, personal digital assistants (PDAs), laptop computers, digital cameras, camcorders, viewfinders, micro-displays, 3-D displays, vehicles, a large area wall, theater or stadium screen, or a sign. Various control mechanisms may be used to control devices fabricated in accordance with the present invention, including passive matrix and active matrix. Many of the devices are intended for use in a temperature range comfortable to humans, such as 18 degrees C. to 30 degrees C., and more preferably at room temperature (20-25 degrees C.), but could be used outside this temperature range, for example, from -40 degree C to +80 degree C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

It is to be appreciated that the Detailed Description section, and not the Summary and Abstract sections, is intended to be used to interpret the claims. The Summary and Abstract sections may set forth one or more but not all exemplary embodiments of the present invention as contemplated by the inventor(s), and thus, are not intended to limit the present invention and the appended claims in any way.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention as defined in the appended claims. Therefore, such adaptations and modifications are intended to be within the meaning and range of equivalents of the disclosed embodiments, based on the teaching and guidance presented herein. It is to be understood that the phraseology or terminology herein is for the purpose of description and not of limitation, such that the terminology or phraseology of the present specification is to be interpreted by the skilled artisan in light of the teachings and guidance.

## Claims

1. A method of fabricating an organic light emitting device (OLED) on a substrate, comprising:

   providing (300) a flexible mold (600) having surface features, wherein the mold is attached to a conveyor belt (800), wherein the mold moves with the conveyor belt, wherein the surface features are arranged to produce features on a substrate, and wherein the surface features are configured to enhance light extraction;
   forming (310) the substrate over the mold;
   fabricating (320) an OLED over the substrate while the substrate is in the mold; and
   removing (330) the mold from the substrate having the OLED fabricated thereon,
   wherein the mold is removed from the substrate by separating the mold from the substrate when the mold bends around a roller of the conveyor belt, and
   wherein after removing the mold from the substrate, the substrate having the OLED fabricated thereon is flexible, and wherein a flexibility of the mold is greater than a flexibility of an assembly of the substrate and the OLED.

2. The method of claim 1, further comprising applying a release coating over the mold prior to forming the substrate.

3. The method of any of claims 1 to 2, wherein the substrate is formed by applying a coating over the mold; and optionally wherein the coating is formed by applying a liquid to the mold, and subsequently curing the liquid prior to fabricating the OLED.

4. The method of any of claims 1-3, further comprising applying a barrier layer over the substrate before fabricating the OLED; and/or further comprising depositing a barrier layer over the OLED before removing the mold from the substrate.

5. The method of any one of claims 1 to 4, wherein a refractive index of the substrate is greater than 1.6.

6. The method of any one of claims 1 to 5, wherein the surface features of the mold have a peak-to-trough height of at least 200 nm.

7. The method of any one of claims 1 to 6, wherein the substrate is transparent.

8. The method of any one of claims 1 to 7, wherein the surface features of the mold result in the substrate having formed thereon surface features selected from spherical lenses, aspherical lenses, groves, prisms, irregular features that have larger dimensions at the base.

9. An apparatus, comprising:

a conveyor belt, and a mechanism to move the belt; and
a flexible mold attached the belt, wherein the mold moves with the conveyor belt, wherein the flexible mold having surface features, wherein the surface features are arranged to produce features on a substrate material, and wherein the surface features are configured to enhance light extraction,
wherein the following are disposed in order along a path of the belt:

a dispenser attached to a source of substrate material;
an energy source adapted to treat the substrate material;
a plurality of dispensers attached to sources of organic light emitting device, OLED,
materials; and
a mechanism adapted to remove an assembly of the substrate material and organic light emitting device materials from the mold, wherein removal of the assembly of the substrate material and organic light emitting device materials from the mold comprises a separation of the mold from the substrate when the mold bends around a roller of the conveyor belt, and
wherein after removing the assembly from the mold, the substrate having the OLED materials is flexible.

**Patentansprüche**

1. Verfahren zur Herstellung einer organischen lichtemittierenden Vorrichtung (OLED) auf einem Substrat, umfassend:

Bereitstellen (300) einer flexiblen Form (600) mit Oberflächenmerkmalen, wobei die Form an einem Förderband (800) befestigt ist, wobei sich die Form mit dem Förderband bewegt, wobei die Oberflächenmerkmale so angeordnet sind, dass sie Merkmale auf einem Substrat erzeugen, und wobei die Oberflächenmerkmale so beschaffen sind, dass sie die Lichtextraktion verbessern,
Formen (310) des Substrats über der Form,
Herstellen (320) einer OLED über dem Substrat, während sich das Substrat in der Form befindet, und
Entfernen (330) der Form von dem Substrat, auf dem die OLED hergestellt wurde, wobei die Form von dem Substrat entfernt wird, indem die Form von dem Substrat getrennt wird, wenn sich die Form um eine Rolle des Förderbandes biegt, und wobei nach dem Entfernen der Form von dem Substrat das Substrat mit der darauf hergestellten OLED flexibel ist, und wobei eine Flexibilität der Form größer ist als eine Flexibilität einer Anordnung aus dem Substrat und der OLED.

2. Verfahren nach Anspruch 1 ferner umfassend Aufbringen einer Trennbeschichtung auf die Form vor dem Formen des Substrats.

3. Verfahren nach einem der Ansprüche 1 bis 2, bei dem das Substrat durch Aufbringen einer Beschichtung auf die Form gebildet wird, und bei dem die Beschichtung optional durch Aufbringen einer Flüssigkeit auf die Form und anschließendes Aushärten der Flüssigkeit vor der Herstellung der OLED gebildet wird.

4. Verfahren nach einem der Ansprüche 1 bis 3, ferner umfassend Aufbringen einer Sperrschicht auf das Substrat vor der Herstellung der OLED und/oder das Aufbringen einer Sperrschicht auf die OLED vor dem Entfernen der Form vom Substrat.

5. Verfahren nach einem der Ansprüche 1 bis 4, wobei der Brechungsindex des Substrats größer als 1,6 ist.

6. Verfahren nach einem der Ansprüche 1 bis 5, wobei die Oberflächenmerkmale der Form eine Spitze-zu-Talsohle- (Peak-to-Trough-) Höhe von mindestens 200 nm aufweisen.

7. Verfahren nach einem der Ansprüche 1 bis 6, wobei das Substrat transparent ist.

8. Verfahren nach einem der Ansprüche 1 bis 7, wobei die Oberflächenmerkmale der Form dazu führen, dass auf dem Substrat Oberflächenmerkmale ausgebildet sind, die ausgewählt sind aus sphärischen Linsen, asphärischen Linsen, Rillen, Prismen und unregelmäßigen Merkmalen, die an der Basis größere Abmessungen aufweisen.

9. Gerät, aufweisend:

ein Förderband und einen Mechanismus zum Bewegen des Bandes, und
eine an dem Band befestigte flexible Form, wobei sich die Form mit dem Förderband bewegt, wobei die elastische Form Oberflächenmerkmale aufweist, wobei die Oberflächenmerkmale so angeordnet sind, dass sie Merkmale auf einem Substratmaterial erzeugen, und wobei die Oberflächenmerkmale so gestaltet sind, dass sie die Lichtextraktion verbessern,
wobei die folgenden Elemente in der Reihenfolge entlang einer Bahn des Bandes angeordnet sind:

ein Spender, der an einer Quelle von Substratmaterial angebracht ist;
eine Energiequelle, die zur Behandlung des Substratmaterials geeignet ist;
eine Vielzahl von Spendern, die an Quellen von Materialien für organische lichtemittierende Vorrichtungen, OLED, angebracht sind; und
ein Mechanismus, der ausgestaltet ist, eine Anordnung aus dem Substratmaterial und den Materialien für organische lichtemittierende Vorrichtungen aus der Form zu entfernen, wobei das Entfernen der Anordnung aus dem Substratmaterial und den Materialien für organische lichtemittierende Vorrichtungen aus der Form eine Trennung der Form von dem Substrat umfasst, wenn sich die Form um eine Rolle des Förderbandes biegt, und wobei das Substrat mit den OLED-Materialien nach der Entnahme der Anordnung aus der Form flexibel ist.

## Revendications

1. Procédé de fabrication d'un dispositif électroluminescent organique (Organic Light Emitting Device, OLED) sur un substrat, comprenant :

la fourniture (300) d'un moule souple (600) ayant des motifs de surface, dans lequel le moule est fixé à une bande transporteuse (800), dans lequel le moule se déplace avec la bande transporteuse, dans lequel les motifs de surface sont agencés pour produire des motifs sur un substrat, et dans lequel les motifs de surface sont configurés pour améliorer l'extraction de lumière ;
la formation (310) du substrat sur le moule ;
la fabrication (320) d'un OLED sur le substrat pendant que le substrat est dans le moule ; et
le retrait (330) du moule du substrat sur lequel est fabriqué l'OLED, dans lequel le moule est retiré du substrat en séparant le moule du substrat lorsque le moule se plie autour d'un rouleau de la bande transporteuse, et dans lequel, après avoir retiré le moule du substrat, le substrat sur lequel est fabriqué l'OLED est souple, et dans lequel la souplesse du moule est supérieure à la souplesse d'un assemblage du substrat et de l'OLED.

2. Procédé selon la revendication 1, comprenant en outre l'application d'un revêtement antiadhésif sur le moule avant de former le substrat.

3. Procédé selon l'une quelconque des revendications 1 et 2, dans lequel le substrat est formé en appliquant un revêtement sur le moule ; et éventuellement dans lequel le revêtement est formé en appliquant un liquide sur le moule, puis en durcissant le liquide avant de fabriquer l'OLED.

4. Procédé selon l'une quelconque des revendications 1 à 3, comprenant en outre l'application d'une couche barrière sur le substrat avant de fabriquer l'OLED ; et/ou comprenant en outre le dépôt d'une couche barrière sur l'OLED avant de retirer le moule du substrat.

5. Procédé selon l'une quelconque des revendications 1 à 4, dans lequel l'indice de réfraction du substrat est supérieur à 1,6.

6. Procédé selon l'une quelconque des revendications 1 à 5, dans lequel les motifs de surface du moule ont une hauteur sommet-creux d'au moins 200 nm.

**7.** Procédé selon l'une quelconque des revendications 1 à 6, dans lequel le substrat est transparent.

**8.** Procédé selon l'une quelconque des revendications 1 à 7, dans lequel les motifs de surface du moule ont pour résultat que le substrat présente des motifs de surface sélectionnés parmi des lentilles sphériques, des lentilles asphériques, des groves, des prismes et des motifs irréguliers qui ont des dimensions plus grandes à la base.

**9.** Appareil, comprenant :

une bande transporteuse et un mécanisme pour déplacer la bande ; et
un moule souple fixé à la bande, dans lequel le moule se déplace avec la bande transporteuse, dans lequel le moule souple possède des motifs de surface, dans lequel les motifs de surface sont agencés pour produire des motifs sur un matériau de substrat, et dans lequel les motifs de surface sont configurés pour améliorer l'extraction de lumière,
dans lequel les éléments suivants sont disposés dans l'ordre le long d'un trajet de la bande :

un distributeur fixé à une source de matériau de substrat ; une source d'énergie adaptée pour traiter le matériau de substrat ;
une pluralité de distributeurs fixés à des sources de matériaux de dispositif électroluminescent organique (Organic Light Emitting Device, OLED) ; et
un mécanisme adapté pour retirer du moule un assemblage constitué du matériau de substrat et des matériaux de dispositif électroluminescent organique, dans lequel le retrait de l'assemblage du matériau de substrat et des matériaux de dispositif électroluminescent organique du moule comprend une séparation du moule du substrat lorsque le moule se plie autour d'un rouleau de la bande transporteuse, et
dans lequel, après avoir retiré l'ensemble du moule, le substrat comportant les matériaux OLED est souple.

FIGURE 1

200

230

225

220

215

210

**FIGURE 2**

```
┌─────────────────────┐
│                     │      300
│  Providing a mold   │  ⌇
│                     │
└─────────────────────┘
           │
           ▼
┌─────────────────────┐
│                     │      310
│   Forming a         │  ⌇
│   substrate         │
│                     │
└─────────────────────┘
           │
           ▼
┌─────────────────────┐
│                     │      320
│  Fabricating an     │  ⌇
│  OLED               │
│                     │
└─────────────────────┘
           │
           ▼
┌─────────────────────┐
│ Removing the mold   │      330
│ from the substrate  │  ⌇
│ and OLED            │
└─────────────────────┘
```

**FIGURE 3**

321

322

Applying an anode

323

Applying organic material

324

Applying a cathode

325

Applying a barrier layer

326

Applying a hard coat

**FIGURE 4**

Providing a mold ⟋500

↓

Forming a substrate ⟋510

↓

Applying electrodes and organic matter ⟋520

↓

Applying a barrier layer ⟋530

↓

Applying a first hard coat ⟋540

↓

Removing the mold from the substrate and OLED ⟋550

↓

Applying a second hard coat ⟋560

**FIGURE 5**

FIGURE 6A)

602
600

FIGURE 6B)

610

FIGURE 6C)

626
624 } 620
622

FIGURE 6D)

630

FIGURE 6E)

640
642

FIGURE 6F)

650

FIGURE 6G)

662
660

**FIGURE 7A)**

600'

604

626

**FIGURE 7B)**

640

642

630

624

622

610

**FIGURE 7C)**

650

FIGURE 8

EP 3 624 207 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2008139370 A1
- WO 2004051738 A2
- US 2012228601 A1
- US 5844363 A
- US 6303238 B
- US 5707745 A
- US 4769292 A
- US 7279704 B
- US 20030230980
- US 5703436 A
- US 6097147 A
- US 20040174116

- US 5247190 A, Friend
- US 6091195 A, Forrest
- US 5834893 A, Bulovic
- US 6013982 A
- US 6087196 A
- US 6337102 B, Forrest
- US 7431968 B
- US 6294398 B
- US 6468819 B
- US 7968146 B
- US 2007023098 W
- US 2009042829 W

### Non-patent literature cited in the description

- **BALDO et al.** Highly Efficient Phosphorescent Emission from Organic Electroluminescent Devices. *Nature,* 1998, vol. 395, 151-154

- **BALDO et al.** Very high-efficiency green organic light-emitting devices based on electrophosphorescence. *Appl. Phys. Lett.,* 1999, vol. 75 (3), 4-6
- **J. A. ROGERS ; G. R. BOGART.** *J. Mater. Res.,* 2001, vol. 16 (1), 217